# EUROPEAN PATENT SPECIFICATION

(11) **EP 1 222 685 B1**
(45) Date of publication and mention of the grant of the patent: **17.02.2010**
(21) Application number: 00970767.0
(22) Date of filing: 11.10.2000
(51) Int. Cl.: H01L 21/20, H01L 21/205

(54) **SINGLE STEP PENDEO- AND LATERAL EPITAXIAL OVERGROWTH OF GROUP III-NITRIDE LAYERS**
EINSTUFIGE PENDEO- ODER LATERALE EPITAXIE VON GRUPPE III-NITRIDSCHICHTEN
CROISSANCE PENDEOEPITAXIALE ET EPITAXIALE LATERALE EN UNE SEULE ETAPE DE COUCHES EPITAXIALES DE NITRURE DE GROUPE III

(30) Priority: 14.10.1999 US 159299 P
(43) Date of publication of application: 17.07.2002
(73) Proprietor: CREE, INC., Durham, NC 27703 (US)
(72) Inventor: KONG, Hua-shuang, Raleigh, NC 27606 (US); EDMOND, John, Adam, Cary, NC 27511 (US); HABERERN, Kevin, Ward, Cary, NC 27511 (US); EMERSON, David, Todd, Durham, NC 27707 (US)
(74) Representative: Bankes, Stephen Charles Digby
(86) International application number: PCT/US2000/028056
(87) International publication number: WO 2001/027980

(56) References cited:
- WO-A-99/23693
- US-A- 4 971 928
- MARX D ET AL: "Selective area growth of GaN/AlN heterostructures" JOURNAL OF CRYSTAL GROWTH, vol. 189-190, June 1998 (1998-06), pages 87-91, XP004148481 ISSN: 0022-0248
- PATENT ABSTRACTS OF JAPAN vol. 1999, no. 02, 26 February 1999 (1999-02-26) & JP 10 312971 A (NEC CORP), 24 November 1998 (1998-11-24) -& JP 10 312971 A (NEC CORP) 24 November 1998 (1998-11-24)
- DUPUIS R D ET AL: "Selective-area and lateral epitaxial overgrowth of III-N materials by metalorganic chemical vapor deposition" JOURNAL OF CRYSTAL GROWTH, vol. 195, no. 1-4, December 1998 (1998-12), pages 340-345, XP004154285 ISSN: 0022-0248
- KUNG P ET AL: "Lateral epitaxial overgrowth of GaN films on sapphire and silicon substrates" APPLIED PHYSICS LETTERS, vol. 74, no. 4, 25 January 1999 (1999-01-25), pages 570-572, XP000805771 ISSN: 0003-6951
- ZHELEVA T S ET AL: "Pendeo-epitaxy - A new approach for lateral growth of gallium nitride structures" MRS INTERNET JOURNAL OF NITRIDE SEMICONDUCTOR RESEARCH, 1999, vol. 4S1, no. G3.38, 30 November 1998 (1998-11-30) - 4 December 1998 (1998-12-04), XP002117241 1998 MRS FALL MEETING - SYMPOSIUM ON 'GAN AND RELATED ALLOYS', BOSTON, USA ISSN: 1092-5783
- SMART J A ET AL: "Single step process for epitaxial lateral overgrowth of GaN on SiC and sapphire substrates" APPLIED PHYSICS LETTERS, vol. 75, no. 24, 13 December 1999 (1999-12-13), pages 3820-3822, XP000893595 ISSN: 0003-6951
- KIDOGUCHI I ET AL: "Improvement of crystalline quality in GaN films by air-bridged lateral epitaxial growth" JAPANESE JOURNAL OF APPLIED PHYSICS, PART 2 (LETTERS), vol. 39, no. 5B, 15 May 2000 (2000-05-15), pages L453-L456, XP002159288 ISSN: 0021-4922

## Description

### Field of the Invention

The present invention relates to electronic device structures and fabrication methods, and more particularly to Group III-nitride semiconductor structures and methods of fabrication by pendeo- and lateral epitaxial overgrowth.

### Background

Gallium nitride (GaN) is a wide-bandgap semiconductor material widely known for its usefulness as an active layer in blue light emitting diodes. GaN is also under investigation for use in other microelectronic devices including laser diodes and highspeed, high power transistor devices. As used herein, "gallium nitride" or "GaN" refers to gallium nitride and III-nitride alloys thereof, including aluminum gallium nitride (AlGaN), indium gallium nitride (InGaN) and aluminum indium gallium nitride (AlInGaN).

High-quality bulk crystals of GaN are currently unavailable for commercial use. Thus, GaN crystals are typically fabricated as heteroepitaxial layers on underlying non-GaN substrates. Unfortunately, GaN has a considerable lattice mismatch with most suitable substrate crystals. For example, GaN has a 15% lattice mismatch with sapphire and a 3.5% lattice mismatch with silicon carbide. Lattice mismatches between a substrate and an epitaxial layer cause threading dislocations which may propagate through the growing epitaxial layer. Even when grown on silicon carbide with an aluminum nitride buffer layer, a GaN epitaxial layer exhibits dislocation densities estimated to be in excess of 10⁸/cm². Such defect densities limit the usefulness of GaN in highly sensitive electronic devices such as laser diodes.

Lateral Epitaxial Overgrowth (LEO) of GaN has been the subject of considerable interest since it was first introduced as a method of reducing the dislocation densities of epitaxially grown GaN films. Essentially, the technique consists of masking an underlying layer of GaN with a mask having a pattern of openings and growing the GaN up through and laterally onto the mask. It was found that the portion of the GaN layer grown laterally over the mask exhibits a much lower dislocation density than the underlying GaN layer or the portion of the GaN layer above the mask openings. As used herein, "lateral" or "horizontal" refers to a direction generally parallel to the surface of a substrate, while the term "vertical" means a direction generally orthogonal to the surface of a substrate.

One drawback to conventional LEO techniques is that separate process steps are required for growing the underlying GaN layer, masking the GaN layer and then growing the lateral layer. Early embodiments of LEO did not place the mask directly on the non-GaN substrate because unwanted nucleation would occur on the mask during nucleation of the GaN layer at low temperatures, preventing adjacent laterally-grown regions from coalescing (or otherwise from growing laterally a desired distance if coalescence is not required). When the mask is placed directly on a GaN layer, unwanted nucleation on the mask is typically not a problem since low temperature nucleation is not required and the growth temperature of GaN is very high, typically above 1000°C. During high temperature growth, unwanted nucleation does not occur on the mask due to the much higher sticking coefficient of gallium atoms on the gallium nitride surface as compared to the mask.

This drawback is addressed with some success by a "single step" process for LEO. Shealy et al. WO 01/25511A1 disclosed a process whereby an underlying SiC or sapphire substrate was masked with silicon nitride. The process is referred to as "single step" because it does not require growth of an intermediate layer of GaN between the substrate and the mask. Shealy found that minimizing nucleation on the silicon nitride mask permitted growth of a relatively defect free layer of laterally-grown GaN over the masks. However, under certain circumstances it is desirable to avoid having to minimize nucleation on the mask, yet still be able to grow a relatively defect free layer of GaN in a single step process.

Accordingly, there is a need in the art for a method of fabricating a relatively defect-free single crystal film of gallium nitride in a single step process without having to minimize nucleation on the mask layer.

Moreover, there is a need in the art for such a method which provides a conductive buffer layer to permit electrical communication between a conductive substrate and an epitaxial layer of gallium nitride.

The present invention consists in a method of fabricating a gallium nitride-based semiconductor structure on a substrate, the method comprising:
forming a mask having an opening on the substrate;
growing on the substrate surface, through the opening in the mask, a buffer layer that will support the epitaxial growth of Group III nitrides through the opening in the mask; growing an epitaxial layer that has a composition different from the buffer layer and that is selected from gallium nitride and Group III nitride alloys of gallium nitride vertically from the buffer layer and laterally across the mask during which growth polycrystalline nitride material is nucleated on the mask; and
maintaining the lateral growth rate of the epitaxial layer sufficiently greater than the vertical growth rate of the epitaxial layer to prevent the polycrystalline nitride material nucleated on the mask from interrupting the lateral growth of the epitaxial layer across the mask.

In one embodiment, the method includes forming trenches in the substrate and forming a mask having at least one opening over the upper surface of an intermediate portion of the substrate adjacent to or between said trenches. A buffer layer may be grown from the upper surface of the intermediate portion. The gallium nitride layer is then grown laterally by pendeoepitaxy over the trenches.

The structure produced by the method of the invention includes a substrate and a mask having at least one window therein applied directly on the upper surface of the substrate. An overgrown layer of gallium nitride extends upwardly from the mask window and laterally across the mask, on which polycrystalline material may have nucleated and grown.

In another embodiment, trenches are formed in the surface of the substrate. A mask structure overlays the substrate adjacent the trenches and a window in the mask exposes at least a portion of the upper surface of the substrate. An overgrown layer of gallium nitride extends upwardly from the mask window and laterally over the trench and across the mask, on which polycrystalline material may have nucleated and grown.

Preferred embodiment of the invention will now be described with reference to the accompanying drawings wherein:
FIG. 1 is a cross-section of a substrate on which a mask has been patterned.
FIG. 2 is a plan view of a substrate on which a mask has been patterned.
FIG. 3 is a cross section of a substrate on which a layer of GaN has been epitaxially grown by LEO on a conductive buffer layer.
FIG. 3A is a cross section of a substrate on which a layer of GaN is being epitaxially grown by LEO on a conductive buffer layer, but has not coalesced.
FIG. 4 is a cross section of a substrate on which excessive nucleation on the mask has interrupted the lateral growth of a layer of GaN.
FIG. 5 is a cross section of a substrate on which a layer of GaN has been epitaxially grown in accordance with an aspect of the present invention.
FIG. 6 is a cross section of a substrate on which a layer of GaN has been epitaxially grown in accordance with another aspect of the present invention.
FIG. 6A is a cross section of a substrate on which a pair of raised portions has been formed and a mask layer has been deposited.
FIG. 6B is a cross section of a substrate on which a pair of raised portions has been formed and a mask layer has been deposited using a self-alignment technique.
FIG. 7 is a cross-sectional SEM image showing the interruption of lateral growth of a GaN layer by crystals nucleating on the mask.
FIG. 8 is a plan view SEM image of two GaN stripes in which crystallites on the underlying mask disturbed the epitaxial growth.
FIG. 9 is a cross-sectional SEM of GaN stripes grown in accordance with an embodiment of the present invention using a reflective mask layer.
FIG. 10 is a cross-sectional SEM of GaN stripes grown in accordance with an embodiment of the present invention until adjacent regions have coalesced over the reflective masks.
FIG. 11 is a cross-sectional SEM of a GaN layer grown on a conductive buffer layer over a Si₃N₄ mask.
FIG. 12 is a cross sectional SEM of a GaN layer grown in accordance with a second embodiment of the present invention.
FIG. 13 is a plan view SEM image of two GaN stripes grown in accordance with the second embodiment of the present invention.
FIG. 14 is a cross-sectional TEM (Transmission Electron Microscopy) image of a layer of GaN grown in accordance with the present invention.
FIG. 15 is a cross-sectional SEM of GaN stripes grown in accordance with an embodiment of the present invention while maintaining a ratio of lateral to horizontal growth rates of 4.2:1.
FIG. 16 is a cross-sectional SEM of GaN stripes grown in accordance with an embodiment of the present invention while maintaining a ratio of lateral to horizontal growth rates of 1:1.

### Detailed Description of the Invention

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout. Furthermore, the various layers and regions illustrated in the figures are illustrated schematically. As will also be appreciated by those of skill in the art, references herein to a layer formed "on" a substrate or other layer may refer to the layer formed directly on the substrate or other layer or on an intervening layer or layers formed on the substrate or other layer. References herein to a layer formed "directly on" a substrate or other layer refer to the layer formed on the substrate without an intervening layer or layers formed on the substrate or other layer. The present invention is not limited to the relative size and spacing illustrated in the accompanying figures.

Basic LEO techniques are described in A. Usui, et al., "Thick GaN epitaxial growth with low dislocation density by hydride vapor phase epitaxy," Jpn. J. Appl. Phys. Vol. 36, pp. L899-902 (1997).

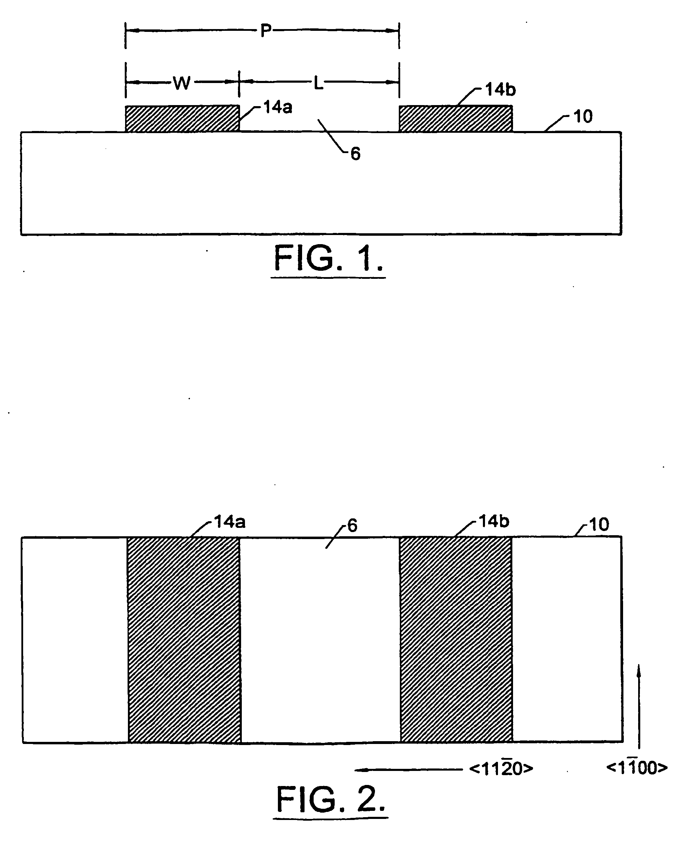

Referring now to FIG. 1, a substrate 10 is illustrated on which is deposited a mask layer 14 comprising stripes 14a and 14b. Although the stripe pattern may continue in a periodic or aperiodic fashion on either side, for convenience only stripes 14a and 14b are illustrated. Stripes 14a, 14b are characterized in that they have a width (w) and are separated by mask openings or windows 6 having a window length (1). The distance between an edge of stripe 14a and the corresponding edge of stripe 14b is defined as the period (p) of the mask pattern, at least with respect to stripes 14a and 14b, such that p=w+1.

The mask layer may be deposited using plasma enhanced chemical vapor deposition (PECVD), sputtering, electron-beam deposition, thermal oxidation or other deposition techniques, and patterned using standard photolithographic techniques. The PECVD process is described in detail in Chapter 6 of S.M. Sze, VLSI Technology, 2nd ed., McGraw-Hill 1988. Photolithographic techniques are well known in the art.

As illustrated in FIG. 2, stripes 14a and 14b are preferably oriented along the < 11̅00 > crystallographic direction in the (0001) plane. (Crystallographic designation conventions used herein are well known in the art and need not be described further.) The mask layer 14 may comprise silicon nitride (SiₓN_{y}) or silicon dioxide (SiO₂) or any other suitable mask material. If the structure being fabricated is intended for use in an optical device such as an LED or laser diode, the mask layer 14 may comprise a reflective or refractory metal which is stable in ammonia and hydrogen gas, has a melting point in excess of about 1200°C, and is reflective to the desired wavelength. Examples of such metals include tungsten (W) and platinum (Pt). Alternatively, the mask layer could comprise a Bragg reflector which may comprise alternating layers of SiₓN_{y} and SiO₂ or other oxides, the design of which is well known in the art.

The substrate may be silicon carbide, sapphire (Al₂O₃), silicon, ZnO, or any other similarly suitable substrate. Silicon carbide substrates are advantageous for a number of reasons. Silicon carbide provides closer lattice and thermal expansion matches for GaN, is thermally and chemically stable, has natural cleave planes, high thermal conductivity, and is transparent to visible wavelengths up to 380 nm. Also, silicon carbide has a distinct advantage in that it is conductive, which permits fabrication of vertical-geometry devices. Silicon carbide substrates may have a polytype of 4H, 6H, 3C or 15R. Preferably, however, the substrate is 6H-SiC (on-axis).

The fabrication of substrate 10 is well known to those in the art. Fabrication of silicon carbide substrates are described, for example, in U.S. Patents 4,865,685 to Palmour et al., Re34,861 to Davis, et al., 4,912,064 to Kong et al., and 4,946,547 to Palmour et al.,. The fabrication of sapphire and silicon substrates is well known in the art and need not be described in detail.

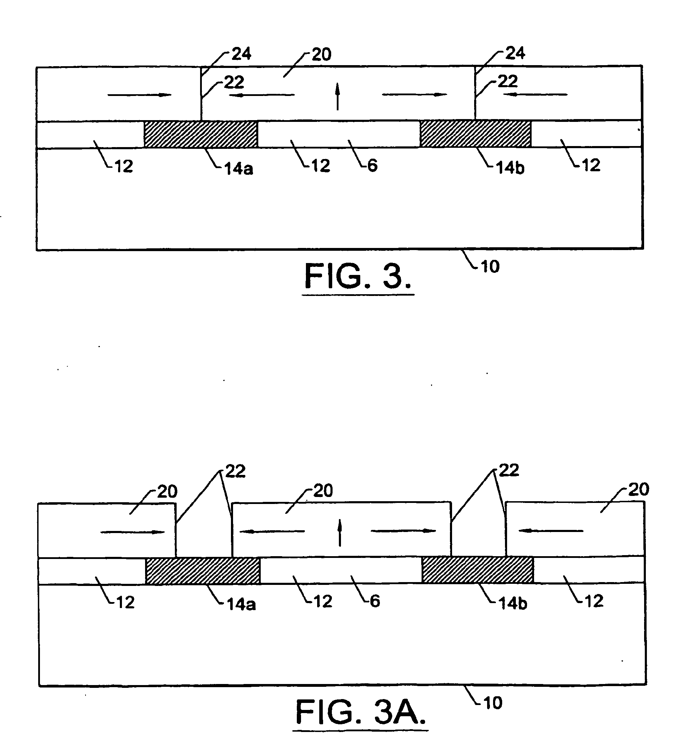

Referring now to FIG. 3, an epitaxial layer 20 may be fabricated by first growing a buffer layer 12 on the surface of the substrate 10. Epitaxial layer 20 may comprise gallium nitride or a Group III-nitride alloy thereof, such as aluminum gallium nitride (AlGaN), indium gallium nitride (InGaN), or aluminum indium gallium nitride (AlInGaN). For a SiC substrate, the buffer layer preferably comprises a layer 12 of AlₓGa₁₋ₓN, where x represents the mole fraction of aluminum present in the alloy and 0 < x ≤ 1.

Preferably, the topmost buffer layer comprises a mole percentage of Al of between 9% and 12%, and is approximately 100 to 500 nm thick. The buffer layer 12 may be made conductive to the SiC substrate by the formation of capped GaN dots on the SiC substrate as described in U.S. Patent Application Serial No. 08/944,547 prior to the deposition of the buffer layer.

For sapphire or silicon substrates, a low temperature GaN, AIN or AIGaN buffer may be grown.

As shown in FIG. 3, an AlGaN buffer layer 12 may be grown vertically from the mask openings 6 using a vapor phase epitaxy (VPE) technique such as hydride vapor phase epitaxy (HVPE), or more preferably metal-organic vapor phase epitaxy (MOVPE). In a preferred embodiment, the buffer layer 12 is grown to a thickness larger than the thickness of the mask layer 14. Once the buffer layer 12 has been grown to a desired thickness, the epitaxial layer 20 is then grown by VPE, preferably in the same run or step as the buffer layer was grown.

As shown in FIG. 3A, epitaxial layer 20 grows laterally (i.e. parallel to the face of the substrate) in addition to vertically. Lateral growth fronts 22 move across the surface of the mask stripes 14 as layer 20 grows.

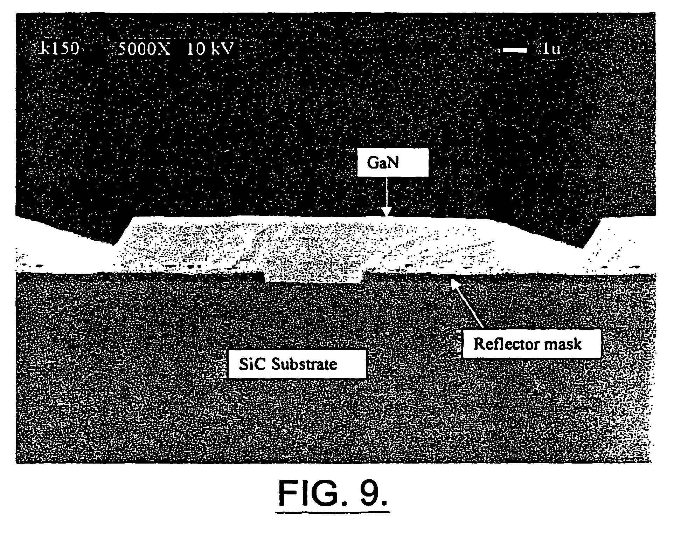

Referring again to FIG. 3, in one embodiment, epitaxial layer 20 grows laterally until the growth fronts 22 coalesce at interfaces 24 to form a continuous layer 20 of gallium nitride. However, it is not necessary for the growth fronts to coalesce for all applications, as it is possible to fabricate devices in laterally overgrown portions of GaN even if they have not coalesced with adjacent portions. As illustrated in FIG. 9, a useful portion of layer 20 may be fabricated without coalescence of adjacent portions. For example, a laser diode stripe may be fabricated in a region of layer 20 that has not coalesced. For fabrication of an LED, a coalesced layer is preferred. For example, an LED device 250µ wide and 275µ long may be fabricated on a coalesced layer of gallium nitride grown in accordance with the present invention.

The buffer layer 12 and the overgrown layer 20 may be grown using trimethylgallium (TMG), trimethylaluminum (TMA) and ammonia (NH₃) precursors in a diluent of H₂. A suitable MOVPE growth technique is described in greater detail in T. Weeks et al., "GaN thin films deposited via organometallic vapor phase epitaxy on α(6H)-SiC(0001) using high-temperature monocrystalline AIN buffer layers," Appl. Phys. Let., Vol. 67, No. 3, July 1995, pp. 401-403.

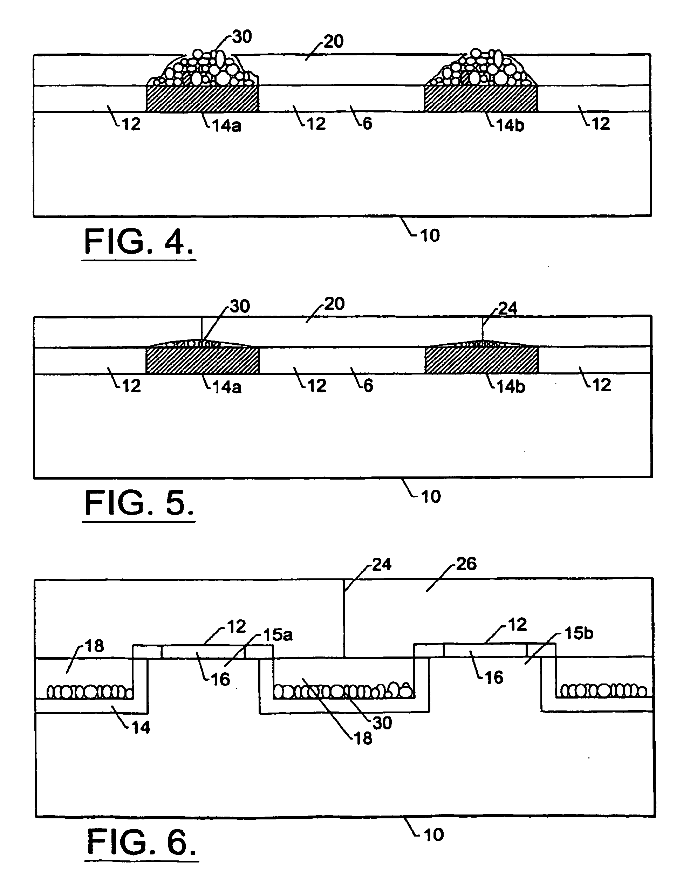

While the layer 20 of gallium nitride is growing, nucleation and growth of polycrystalline AlₓGa₁₋ₓN 30 typically begins to occur on the exposed upper surfaces of mask stripes 14. As illustrated in FIG. 4, if the growth rate of AlₓGa₁₋ₓN on the masks is too high, the lateral growth of layer 20 will be interrupted, preventing it from forming a desired width of laterally overgrown material, and/or preventing it from coalescing with adjacent regions. Essentially, the polycrystalline AlₓGa₁₋ₓN 30 on the mask grows vertically and blocks the lateral growth of the single crystal layer 20.

The present inventors have discovered that it is possible, by controlling the horizontal and vertical growth rates of layer 20, to avoid interruption of the laterally growing layer 20 by the polycrystalline AlₓGa₁₋ₓN 30. By increasing the lateral growth rate of layer 20 relative to its vertical growth rate by a given amount depending on the geometry of the structure, it is possible to grow a layer 20 that will grow to a desired distance despite nucleation on the mask.

Stated differently, by maintaining a sufficiently higher lateral growth rate relative to the vertical growth rate of layer 20, nucleation on the mask need not be controlled, since layer 20 will overgrow any polycrystalline nucleation and growth on the mask.

As a particular example, it has been discovered that by maintaining a ratio of lateral growth rate to vertical growth rate of at least 1:1 (the case where lateral growth rate equals vertical growth rate not being part of this invention), it is possible to grow a laterally-overgrown GaN layer on a stripe having a width of 5 µm in a pattern with a period of 30 µm from a nucleation layer having an Al concentration of about 10%. By maintaining a lateral/vertical growth ratio of 4:1, it is possible to grow a layer of GaN over a mask having 25 µm wide stripes. As shown in FIG. 5, when the lateral growth rate is caused to exceed the vertical growth rate by a sufficient amount, the growth fronts of the layer 20 may coalesce before the polycrystalline AlGaN growing on the stripes 14a,b grow large enough to block them.

The mechanisms for controlling the relevant growth factors will now be described in detail. The lateral and vertical growth rates of the overgrown layer 20 are controlled by a number of factors. One controlling factor is the so called "fill factor", defined herein as the ratio of the window length (1) to the stripe period (p). For a given window length, a higher fill factor (i.e. a larger window length for a given period) results in a slower vertical growth rate. Conversely, for a given window length, a lower fill factor results in an increased vertical growth rate. Other factors for controlling the lateral and vertical growth rates are growth temperature, source gas flow rates, source gas nitrogen/gallium ratio, and growth pressure.

If desired, once the laterally growing growth fronts 22 of the layer 20 have coalesced over the masks, the growth conditions can be adjusted to increase the vertical growth rate.

Although dependent on the structure of the particular epitaxial growth reactor being employed, typical growth parameters for the rates described herein are summarized in the following table.

**Table 1 - Typical growth parameters.**

| **Parameter** | **Value** |
|---|---|
| Growth temperature | 1060-1120°C |
| Growth pressure | 50-200 Torr |
| N/Ga ratio | 2500 |
| Fill factor | 0.714 - 0.833 |
| Lateral growth rate/vertical growth rate | greater than 1 and up to 4.2 |

Preferably, a lateral growth rate of about 2-8 µm hr and a vertical growth rate of about 1-2 µm hr should be selected, while keeping the lateral growth rate larger than the vertical growth rate. A lateral growth rate of 6.3 µm hr and a vertical growth rate of 1.5 µm hr (4.2:1 ratio) may be achieved by growing the layer 20 by MOVPE at 1110°C and 200 Torr on a patterned mask of SiₓN_{y} stripes having a stripe width of 10 µm, a window width of 25 µm and a period of 35 µm for a fill factor of 0.71. The N/Ga ratio during growth of the layer 20 is preferably about 2500. Ratios of lateral growth rate to vertical growth rate may exceed 4.2:1.

To grow the buffer layer, TMG may flowed at 34.8µmol/min, TMA may be flowed at 6.5 µmol/min and ammonia may be flowed at a rate of 10 slpm in a diluent of H₂ at 15.5 slpm. Once the buffer layer has been grown to a desired thickness, the layer 20 may be grown by flowing TMG at 309 µmol/min and ammonia at a rate of 17 slpm in a diluent of H₂ at 22.5 slpm until the GaN layer has grown to a desired thickness.

In an embodiment outside the present invention, a lateral and vertical growth rate of 4.2 µm hr (1:1 ratio) may be achieved by growing the layer 20 by MOVPE at 1060°C and 200 Torr on a patterned mask of SiₓN_{y} stripes having a stripe width of 10 µm, a window length of 25 µm and a period of 35 µm for a fill factor of 0.71. The N/Ga ratio during growth of the layer 20 is preferably about 2500. It will be appreciated that other ratios, including ratios greater than 4.2:1, may be achieved through selection of other growth parameters.

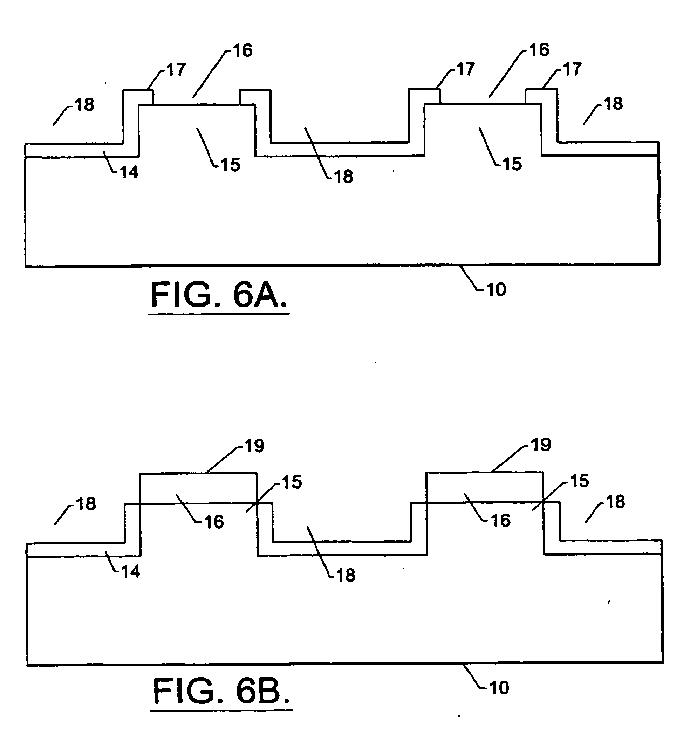

An embodiment of the present invention utilizing pendeoepitaxial growth is illustrated in FIG. 6. In this embodiment, the substrate 10 is etched to form at least one raised portion 15, which defines adjacent recessed areas or trenches 18 on the substrate 10. FIG. 6 illustrates an embodiment in which a pair of raised portions 15a,15b have been patterned using standard photolithographic techniques and reactive ion etching. Preferably, the height of raised portions 15 (i.e. the depth of trenches 18) is at least 1 µm. A mask layer 14, which may be SiₓN_{y}, SiO₂ or any other suitable mask is then deposited on the upper surface of substrate 10, with mask openings 16 made on the upper surfaces of raised portions 15a, 15b.

In this embodiment, the substrate 10 may be silicon carbide, sapphire, silicon, gallium arsenide, gallium nitride or another Group III-nitride such as aluminum nitride or aluminum gallium nitride. The fabrication of aluminum nitride substrates is described in U.S. Patent No. 5,858,086 and 5,954,874 to Hunter. Gallium nitride substrates have been fabricated by growing thick epitaxial layers of gallium nitride on a non-GaN substrate. Other methods of obtaining gallium nitride substrates are summarized in A. Usui, et al., "Thick GaN epitaxial growth with low dislocation density by hydride vapor phase epitaxy," Jpn. J. Appl. Phys. Vol. 36, pp. L899-902 (1997). It will be appreciated by those of skill in the art that when the substrate is a Group III-nitride, homoepitaxial growth may be used.

As shown in FIG. 6, an AlGaN buffer layer 12 may be grown vertically from the mask openings (or windows) 16 using MOVPE. In a preferred embodiment, the buffer layer 12 is grown to a thickness larger than the thickness of the mask layer 14. Once the buffer layer 12 has been grown to a desired thickness, the pendeoepitaxial layer 26 is then grown. Pendeoepitaxial layer 26 grows laterally (i.e. parallel to the face of the substrate) over trenches 18 in addition to vertically.

Although nucleation and growth of polycrystalline GaN 30 may be occurring on the mask 14, it is occurring within trenches 18, and thus does not interfere with the lateral growth of pendeoepitaxial layer 26.

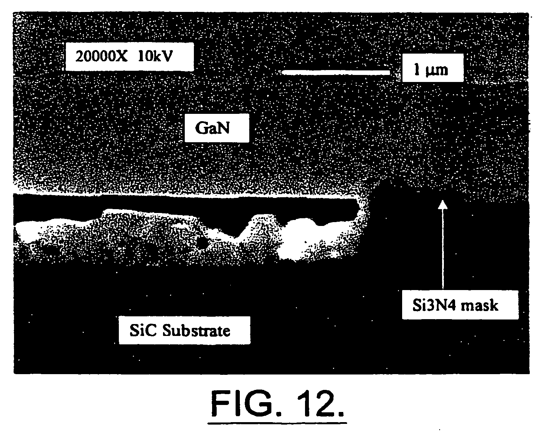

FIG. 12 is a cross sectional SEM of a pendeoepitaxial GaN layer grown in accordance with this embodiment of the invention. Polycrystalline AlGaN material is evident within the trench, but does not interfere with the lateral growth of the GaN layer.

It will be readily appreciated that a trench depth of 1 µm is exemplary. Trenches 18 may be fabricated with depths less than or greater than 1 µm if desired or necessary depending on the rate of polycrystalline growth on the mask or the width of the pendeoepitaxial layer to be grown.

In one embodiment, pendeoepitaxial layer 26 grows laterally until opposing growth fronts 22 coalesce at interfaces 24 to form a continuous layer 26 of gallium nitride. However, as mentioned above, it is not necessary for the growth fronts 22 to coalesce for all applications, as it is possible to fabricate devices in laterally overgrown portions of GaN even if they have not coalesced with adjacent portions.

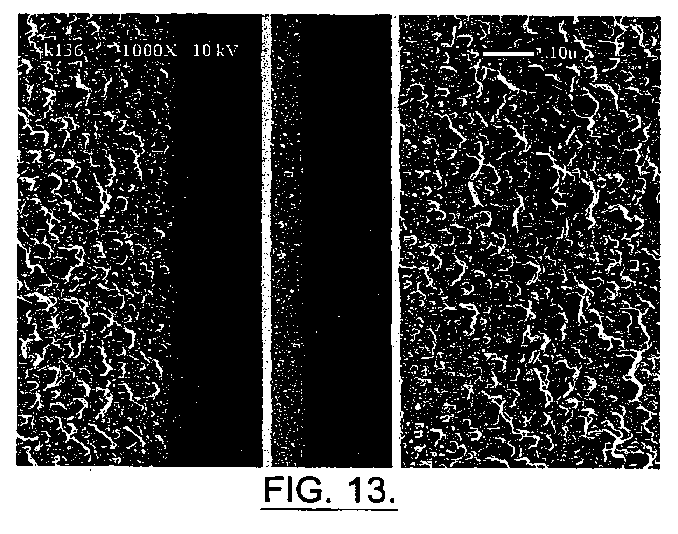

FIG. 13 is a plan view SEM image of two pendeoepitaxial GaN stripes grown in accordance with this embodiment of the present invention.

For the embodiment illustrated in FIG. 6, alternative methods of forming the mask layer 14 are illustrated in FIGs 6A and 6B. As discussed above, raised portions 15 may be formed using standard etching techniques. Typically, this involves patterning the surface of a substrate with an etch mask, etching the substrate to the desired depth, and then removing the etch mask. As shown in FIG. 6A, after the etch mask has been removed, the mask layer 14 may be formed on the surface of substrate 10 by PECVD. Windows 16 are then opened in mask 14 to reveal the upper surfaces of raised portions 15.

Because of the tolerance limitations of photolithographic techniques, when the windows 16 are opened in mask 14, it is difficult to align the edges of windows 16 with the edges of raised portions 15. Thus, there is some overlap 17 of the mask 14 onto the upper surfaces of raised portions 15.

A simplified method of forming mask 14 is illustrated in FIG. 6B. In this method, an etch mask 19 is applied to the surface of substrate 10, and substrate 10 is etched to form trenches 18. Mask 14 is deposited after etching trenches 18 but prior to removing etch mask 19. In this technique, mask 14 preferably comprises a thin mask layer of about 50-200 Å in thickness. Mask 14 may comprise SiₓN_{y}, SiO₂, or any other suitable mask material. Etch mask 19 is then removed, revealing the upper surfaces of raised portions 15. The edges of windows 16 in mask 14 are thereby self-aligned with the edges of raised portions 15. Thus, with this technique, only a single masking step is required and it is not necessary to use photolithographic techniques to open windows 16 in mask layer 14.

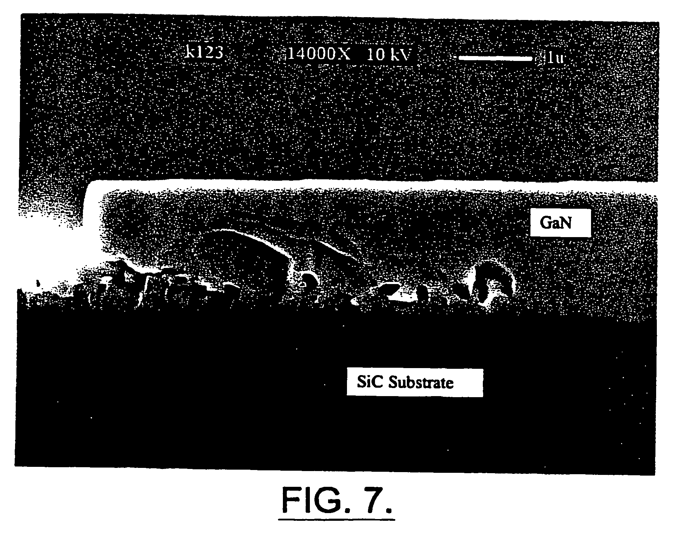

FIG. 7 is a cross-sectional SEM image showing the interruption of lateral growth of a GaN layer by crystals nucleating on the mask.

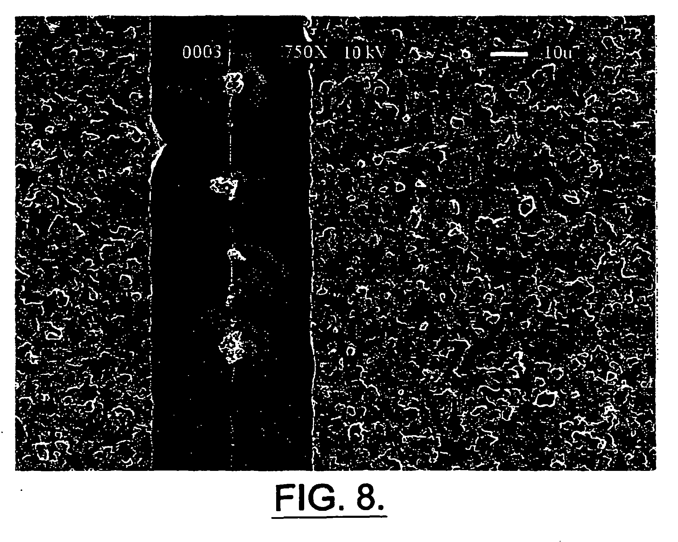

FIG. 8 is a plan view SEM image of two GaN stripes in which crystallites on the underlying mask disturbed the epitaxial growth.

FIG. 9 is a cross-sectional SEM of GaN stripes grown in accordance with an embodiment of the present invention using a reflector mask layer.

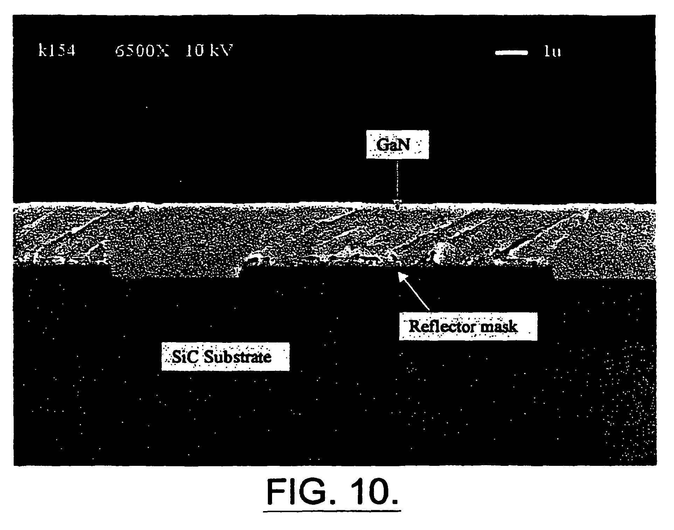

FIG. 10 is a cross-sectional SEM of GaN stripes grown in accordance with an embodiment of the present invention until adjacent regions have coalesced over the masks.

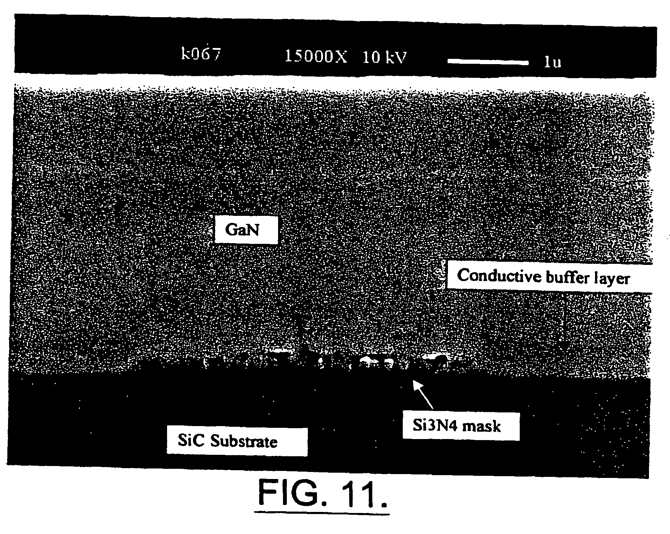

FIG. 11 is a cross-sectional SEM of a GaN layer grown on a conductive buffer layer over a Si₃N₄ mask.

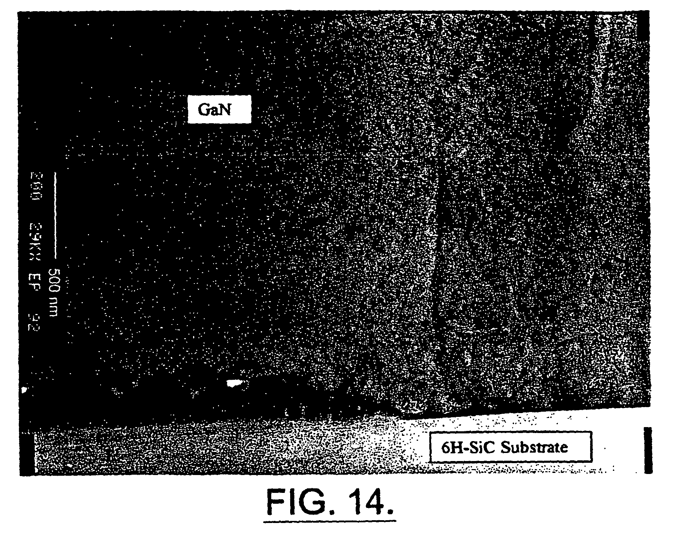

FIG. 14 is a cross-sectional TEM (Transmission Electron Microscopy) image of a layer of GaN grown in accordance with the present invention. The defect densities observed indicate an estimated reduction from approximately 10⁹/cm² in the regions over the windows to approximately 10⁶/cm² in the regions above the mask stripes.

### Example 1:

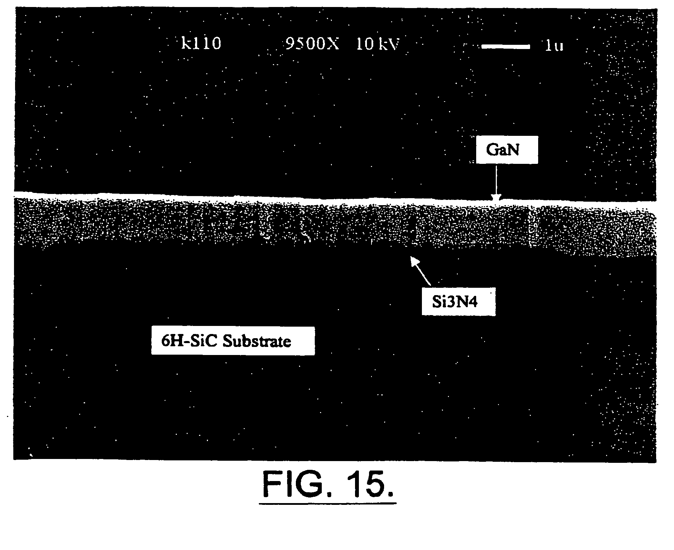

A patterned mask of SiₓN_{y} stripes having a stripe width of 10µ, a window length of 25µ and a period of 35µ for a fill factor of 0.715 was applied to a 6H-SiC substrate. The stripes were arranged parallel to the < 11̅00 > direction. A 0.5µ thick Al_{0.1} Ga_{0.9}N buffer layer was grown by MOVPE by flowing TMG at 34.8µmol/min, TMA at 6.5µmol/min and ammonia at 10 slpm in a diluent of H₂ at 15.5 slpm at 1020°C and 76 Torr for a total of 80 minutes. Following growth of the buffer layer, an epitaxial layer of GaN was grown by MOVPE by flowing TMG at 309 µmol/min and ammonia at 17 slpm in a diluent of H₂ at 22.5 slpm at 1110°C and 200 Torr for 45 minutes. The ratio of lateral to vertical growth under these conditions was approximately 4.2:1. FIG. 15 is an SEM image a cross section of the resulting GaN layer.

### Comparative Example 1

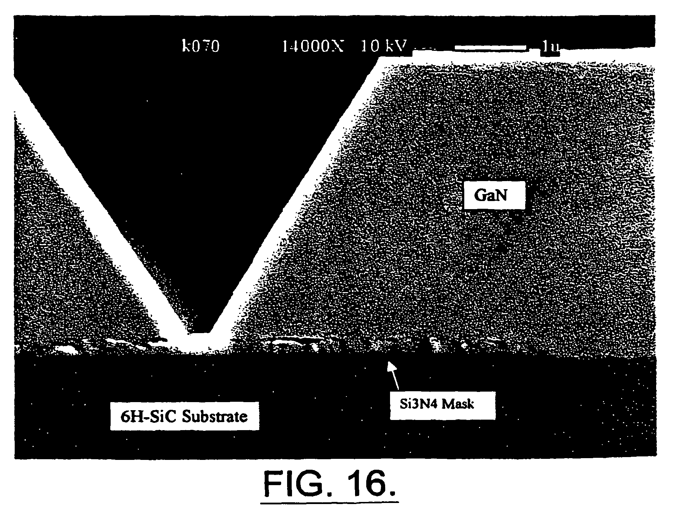

A patterned mask of SiₓN_{y} stripes having a stripe width of 10µ, a window length of 25µ and a period of 35µ for a fill factor of 0.715 was applied to a 6H-SiC substrate. The stripes were arranged parallel to the < 11̅00 > direction. A 0.5µ thick Al_{0.1}Ga_{0.9}N buffer layer was grown by MOVPE by flowing TMG at 34.8µmol/min, TMA at 6.5µmol/min and ammonia at 10 slpm in a diluent of H₂ at 15.5 slpm at 1050°C and 76 Torr for a total of 80 minutes. Following growth of the buffer layer, an epitaxial layer of GaN was grown by MOVPE by flowing TMG at 309 µmol/min and ammonia at 17 slpm in a diluent of H₂ at 22.5 slpm at 1060°C and 200 Torr for one hour. The ratio of lateral to vertical growth under these conditions was approximately 1:1. FIG. 16 is an SEM image a cross section of the resulting GaN layer.

In the specification and drawings, there have been set forth preferred and exemplary embodiments of the invention which have been included by way of example and not by way of limitation, the scope of the invention being set forth in the accompanying claims.

## Claims

1. A method of fabricating a gallium nitride-based semiconductor structure on a substrate (10), the method comprising:
forming a mask (14) having an opening (6) on the substrate;
growing on the substrate surface, through the opening of the mask, a buffer layer (12) that will support the epitaxial growth of Group III nitrides through the opening;
growing an epitaxial layer (20) that has a composition different from the buffer layer and that is selected from gallium nitride and Group III nitride alloys of gallium nitride vertically from the buffer layer and laterally across the mask during which growth polycrystalline nitride material (30) is nucleated on the mask; and
maintaining the lateral growth rate of the epitaxial layer sufficiently greater than the vertical growth rate of the epitaxial layer to prevent the polycrystalline nitride material nucleated on the mask from interrupting the lateral growth of the epitaxial layer across the mask.

2. A fabrication method according to claim 1 **characterised by** the steps of:
forming at least two openings (6) in the mask (14);
maintaining the lateral growth rate of the epitaxial layer (20) sufficiently greater than its vertical growth rate to prevent polycrystalline nitride material (30) nucleating on the mask from interrupting the lateral growth of the epitaxial layer until the lateral growth from the openings coalesces; and
further growing the epitaxial layer vertically after the lateral growth from the openings coalesces.

3. A fabrication method according to claim 1 or claim 2 wherein the substrate (10) includes at least one trench (18), with the mask (14) having said opening (6) therein on a portion (15) of the substrate surface adjacent the trench.

4. A fabrication method according to claim 3 wherein the trench (18) is formed by etching in the substrate (10).

5. A fabrication method according to claim 4 wherein the etching step comprises a reactive ion etch.

6. A fabrication method according to claim 5 wherein:
the etching step comprises etching a plurality of substantially parallel trenches (18) in a silicon carbide substrate (10) that define respective intermediate portions (15) of the substrate surface therebetween; and
wherein the epitaxial layer (26) is selected from gallium nitride and Group III nitride alloys of gallium nitride and is grown vertically and laterally from the buffer layer (12) and extending across a plurality of the trenches.

7. A fabrication method according to any one of claims 3 to 6 comprising the steps of growing the epitaxial layer (26) from at least two portions (15a, 15b) of the substrate surface adjacent to the trench (18) until it coalesces over the trench.

8. A fabrication method according to any one of claims 3 to 7 wherein the step of forming the buffer comprises forming the buffer using vapor phase epitaxy.

9. A fabrication method according to anyone of claims 1 to 8 wherein the ratio of the lateral growth rate to the vertical growth rate of the epitaxial layer (20) is maintained above 1:1 and up to 4.2:1.

10. A fabrication method according to anyone of claims 1 to 8 wherein the ratio of the lateral growth rate to the vertical growth rate of the epitaxial layer (20) is maintained above 4.2:1.

11. A fabrication method according to claim 9 or claim 10 wherein the lateral growth rate of the epitaxial layer (20) is maintained at between 2 and 8 µm per hour.

12. A fabrication method according to any preceding claim wherein the substrate (10) comprises silicon carbide.

13. A fabrication method according to any preceding claim wherein the step of growing the buffer layer (12) comprises growing a layer of AlₓGa₁₋ₓN where 0 < x < 1.

14. A fabrication method according to claim 13 wherein the buffer layer (12) forms a conductive interface to the substrate (10).

15. A fabrication method according to any preceding claim wherein growth of the epitaxial layer (20) is performed at 1060 to 1120°C.

16. A fabrication method according to any preceding claim comprising forming a striped mask (14a, 14b) oriented along the <1100> direction on the (0001) surface of the SiC substrate.

17. A fabrication method according to any preceding claim wherein the buffer layer (12) is grown to a thickness greater than the thickness of the mask (14).

18. A fabrication method according to any preceding claim wherein the epitaxial layer (20) is grown by vapour phase epitaxy using one or more source gases selected from trimethyl gallium, trimethyl aluminium, and ammonia.

19. A fabrication method according to any preceding claim comprising the steps of forming a mask (14) that includes a plurality of said openings (6) and growing the buffer and epitaxial layers (12, 20) from said plurality of the openings.

20. A fabrication method according to claim 2 or claim 4 wherein after the lateral growth from the openings coalesces, the rate of vertical growth of the coalesced epitaxial layer (20) is increased.

21. A fabrication method according to any preceding claim wherein the substrate is masked using a technique selected from plasma-enhanced chemical vapour deposition, sputtering, reactive sputtering, electron-beam deposition and thermal oxidation.

22. A fabrication method according to any preceding claim wherein the buffer layer (12) is grown by vapour phase epitaxy using trimethyl gallium, trimethyl aluminium, and ammonia as the source gases.

23. A fabrication method according to claim 1 wherein the substrate (10) is a silicon carbide substrate, and wherein the buffer layer (12) is a layer of AℓₓGa₁₋ₓN where 0 < X ≤ 1 and is grown to a thickness greater than the thickness of the mask.

## Patentansprüche

1. Verfahren zur Herstellung einer auf Galliumnitrid basierenden Halbleiterstruktur auf einem Substrat (10), wobei man bei dem Verfahren:
eine Maske (14) mit einer Öffnung (6) auf dem Substrat ausbildet,
auf der Substratoberfläche durch die Öffnung der Maske eine Pufferschicht (12) wachsen lässt, die das epitaktische Wachstum von Nitriden der Gruppe III durch die Öffnung unterstützen wird,
eine epitaktische Schicht (20), die eine Zusammensetzung aufweist, die von der Pufferschicht verschieden ist, und die ausgewählt ist unter Galliumnitrid und Gruppe III-Nitrid- Legierungen von Galliumnitrid, vertikal von der Pufferschicht und lateral über die Maske wachsen lässt, wobei sich während dieses Wachstums Keime von polykristallinem Nitridmaterial (30) auf der Maske bilden, und
die laterale Wachstumsrate der epitaktischen Schicht hinreichend größer hält als die vertikale Wachstumsrate der epitaktischen Schicht, um zu verhindern, dass das auf der Maske Keime bildende polykristalline Nitridmaterial das laterale Wachstum der epitaktischen Schicht über die Maske unterbricht.

2. Herstellungsverfahren nach Anspruch 1, **gekennzeichnet durch** die Stufen, bei denen man:
wenigstens zwei Öffnungen (6) in der Maske (14) ausbildet,
die laterale Wachstumsrate der epitaktischen Schicht (20) hinreichend größer hält als dessen vertikale Wachstumsrate, um zu verhindern, dass das auf der Maske Keime bildende polykristalline Nitridmaterial (30) das laterale Wachstum der epitaktischen Schicht unterbricht, bis das laterale Wachstum aus den Öffnungen koalesziert und
die epitaktische Schicht weiter vertikal wachsen lässt, nachdem das laterale Wachstum aus den Öffnungen koalesziert.

3. Herstellungsverfahren nach Anspruch 1 oder Anspruch 2, wobei das Substrat (10) wenigstens eine Furche (18) einschließt, wobei die Maske (14) die Öffnung (6) darin auf einem Teil (15) der Substratoberfläche, welcher zu der Furche benachbart ist, aufweist.

4. Herstellungsverfahren nach Anspruch 3, wobei die Furche (18) durch Ätzen in das Substrat (10) ausgebildet wird.

5. Herstellungsverfahren nach Anspruch 4, wobei die Ätzstufe eine reaktive Ionenätzung umfasst.

6. Herstellungsverfahren nach Anspruch 5, wobei:
die Ätzstufe das Ätzen von einer Mehrzahl von im wesentlichen parallelen Furchen (18), die jeweils dazwischenliegende Teile (15) der Substratoberfläche dazwischen definieren, in ein Siliciumkarbidsubstrat (10) umfasst, und
wobei die epitaktische Schicht (26) ausgewählt ist unter Galliumnitrid und Gruppe III-Nitrid-Legierungen von Galliumnitrid und vertikal und lateral von der Pufferschicht (12) wachsen gelassen wird und sich über eine Mehrzahl der Furchen erstreckt.

7. Herstellungsverfahren nach einem der Ansprüche 3 bis 6 mit den Stufen, bei denen man die epitaktische Schicht (26) von wenigstens zwei Teilen (15a, 15b) der zu der Furche (18) benachbarten Substratoberfläche wachsen lässt, bis sie über die Furche koalesziert.

8. Herstellungsverfahren nach einem der Ansprüche 3 bis 7, wobei die Stufe der Ausbildung des Puffers die Ausbildung des Puffers unter Anwendung der Gasphasenepitaxie umfasst.

9. Herstellungsverfahren nach einem der Ansprüche 1 bis 8, wobei das Verhältnis der lateralen Wachstumsrate zu der vertikalen Wachstumsrate der epitaktischen Schicht (20) über 1:1 und bis zu 4.2:1 gehalten wird.

10. Herstellungsverfahren nach einem der Ansprüche 1 bis 8, wobei das Verhältnis der lateralen Wachstumsrate zu der vertikalen Wachstumsrate der epitaktischen Schicht (20) über 4.2:1 gehalten wird.

11. Herstellungsverfahren nach Anspruch 9 oder Anspruch 10, wobei die laterale Wachstumsrate der epitaktischen Schicht (20) bei zwischen 2 und 8 µm pro Stunde gehalten wird.

12. Herstellungsverfahren nach einem der vorangehenden Ansprüche, wobei das Substrat (10) Siliciumkarbid umfasst.

13. Herstellungsverfahren nach einem der vorangehenden Ansprüche, wobei die Stufe des Wachsens der Pufferschicht (12) das Wachsenlassen einer Schicht von AlₓGa₁₋ₓN, wobei 0 < x < 1 beträgt, umfasst.

14. Herstellungsverfahren nach Anspruch 13, wobei die Pufferschicht (12) eine leitfähige Verbindung zu dem Substrat (10) bildet.

15. Herstellungsverfahren nach einem der vorangehenden Ansprüche, wobei das Wachstum der epitaktischen Schicht (20) bei 1060 bis 1120 °C durchgeführt wird.

16. Herstellungsverfahren nach einem der vorangehenden Ansprüche, bei dem man eine gestreifte Maske (14a, 14b), die entlang der <1100>-Richtung auf der (0001)-Oberfläche des SiC-Substrats orientiert ist, ausbildet.

17. Herstellungsverfahren nach einem der vorangehenden Ansprüche, wobei die Pufferschicht (12) bis zu einer Dicke wachsen gelassen wird, die größer ist als die Dicke der Maske (14).

18. Herstellungsverfahren nach einem der vorangehenden Ansprüche, wobei man die epitaktische Schicht (20) durch Gasphasenepitaxie wachsen lässt, wobei man eines oder mehrere Quellgase verwendet, die ausgewählt sind unter Trimethylgallium, Trimethylaluminium und Ammoniak.

19. Herstellungsverfahren nach einem der vorangehenden Ansprüche, mit den Stufen, bei denen man eine Maske (14) ausbildet, die eine Mehrzahl der Öffnungen (6) einschließt, und die Puffer- und epitaktischen Schichten (12, 20) aus der Mehrzahl der Öffnungen wachsen lässt.

20. Herstellungsverfahren nach Anspruch 2 oder Anspruch 4, wobei, nachdem das laterale Wachstum aus den Öffnungen koalesziert, die Rate des vertikalen Wachstums der koaleszierten epitaktischen Schicht (20) erhöht wird.

21. Herstellungsverfahren nach einem der vorangehenden Ansprüche, wobei das Substrat maskiert wird unter Anwendung eines Verfahrens, das ausgewählt ist unter Plasmaverstärkter chemischer Gasphasenabscheidung, Sputtern, reaktives Sputtern, Elektronenstrahlabscheidung und thermische Oxidation.

22. Herstellungsverfahren nach einem der vorangehenden Ansprüche, wobei man die Pufferschicht (12) durch Gasphasenepitaxie unter Verwendung von Trimethylgallium, Trimethylaluminium und Ammoniak als die Quellgase wachsen lässt.

23. Herstellungsverfahren nach Anspruch 1, wobei das Substrat (10) ein Siliciumkarbidsubstrat ist, und wobei die Pufferschicht (12) eine Schicht von AlₓGa₁₋ₓN ist, wobei 0 < x ≤ 1 beträgt, und bis zu einer Dicke wachsen gelassen wird, die größer ist als die Dicke der Maske.

## Revendications

1. Procédé de fabrication d'une structure à semiconducteurs à base de nitrure de gallium sur un substrat (10), comprenant les opérations consistant à :
former un masque (14) ayant une ouverture (6) sur le substrat ;
développer sur la surface du substrat, à travers l'ouverture du masque, une couche tampon (12) qui supportera la croissance épitaxiale de nitrures de groupe III à travers l'ouverture ;
développer une couche épitaxiale (20) qui a une composition différente de la couche tampon et qui est sélectionnée entre le nitrure de gallium et les alliages de nitrure de groupe III de nitrure de gallium verticalement à partir de la couche tampon et latéralement en travers du masque, le matériau de nitrure polycristallin (30) étant nucléé sur le masque pendant cette croissance ; et
maintenir le taux de croissance latérale de la couche épitaxiale à un niveau suffisamment supérieur au taux de croissance verticale de la couche épitaxiale pour empêcher le matériau de nitrure polycristallin nucléé sur le masque d'interrompre la croissance latérale de la couche épitaxiale en travers du masque.

2. Procédé de fabrication selon la revendication 1, **caractérisé par** les étapes consistant à :
former au moins deux ouvertures (6) dans le masque (14) ;
maintenir le taux de croissance latérale de la couche épitaxiale (20) à un niveau suffisamment supérieur à son taux de croissance verticale pour empêcher le matériau de nitrure polycristallin (30) nucléé sur le masque d'interrompre la croissance latérale de la couche épitaxiale jusqu'à la coalescence de la croissance latérale à partir des ouvertures ; et
développer davantage la couche épitaxiale verticalement après la coalescence de la croissance latérale (1) à partir des ouvertures.

3. Procédé de fabrication selon la revendication 1 ou la revendication 2, dans lequel le substrat (10) comprend au moins une tranchée (18), le masque (14) comportant ladite ouverture (6) sur une partie (15) de la surface du substrat contiguë à la tranchée.

4. Procédé de fabrication selon la revendication 3, dans lequel la tranchée (18) est formée par gravure dans le substrat (10).

5. Procédé de fabrication selon la revendication 4, dans lequel l'étape de gravure comprend une gravure ionique réactive.

6. Procédé de fabrication selon la revendication 5, dans lequel
l'étape de gravure comprend la gravure d'une pluralité de tranchées essentiellement parallèles (18) dans un substrat de carbure de silicium (10) qui définissent entre elles des parties intermédiaires respectives (15) de la surface du substrat ; et
dans lequel la couche épitaxiale (26) est sélectionnée entre le nitrure de gallium et des alliages de nitrure de groupe III de nitrure de gallium et est développée verticalement et latéralement à partir de la couche tampon (12) en s'étendant en travers d'une pluralité des tranchées.

7. Procédé de fabrication selon l'une quelconque des revendications 3 à 6, comprenant les étapes de développement de la couche épitaxiale (26) à partir d'au moins deux parties (15a, 15b) de la surface du substrat contiguë à la tranchée (18) jusqu'à sa coalescence pardessus la tranchée.

8. Procédé de fabrication selon l'une quelconque des revendications 3 à 7, dans lequel l'étape de formation du tampon comprend la formation du tampon au moyen d'épitaxie en phase vapeur.

9. Procédé de fabrication selon l'une quelconque des revendications 1 à 8, dans lequel le rapport du taux de croissance latérale au taux de croissance verticale de la couche épitaxiale (20) est maintenu au-dessus de 1 et jusqu'à 1,2:1.

10. Procédé de fabrication selon l'une quelconque des revendications 1 à 8, dans lequel le rapport du taux de croissance latérale au taux de croissance verticale de la couche épitaxiale (20) est maintenu au-dessus de 1,2:1.

11. Procédé de fabrication selon la revendication 9 ou la revendication 10, dans lequel le taux de croissance latérale de la couche épitaxiale (20) est maintenu entre 2 et 8 µm par heure.

12. Procédé de fabrication selon l'une quelconque des revendications précédentes, dans lequel le substrat (10) est constitué de carbure de silicium.

13. Procédé de fabrication selon l'une quelconque des revendications précédentes, dans lequel l'étape de croissance de la couche tampon (12) comprend la croissance d'une couche de AlₓGa₁₋ₓN où 0 < X ≤ 1.

14. Procédé de fabrication selon la revendication 13, dans lequel la couche tampon (12) forme une interface conductrice avec le substrat (10).

15. Procédé de fabrication selon l'une quelconque des revendications précédentes, dans lequel la croissance de la couche épitaxiale (20) est exécutée à 1060 - 1120°C.

16. Procédé de fabrication selon l'une quelconque des revendications précédentes, comprenant la formation d'un masque rayé (14a, 14b) orienté dans la direction 1100 sur la surface (0001) du substrat de SiC.

17. Procédé de fabrication selon l'une quelconque des revendications précédentes, dans lequel la couche tampon (12) est développée à une épaisseur supérieure à l'épaisseur du masque (14).

18. Procédé de fabrication selon l'une quelconque des revendications précédentes, dans lequel la couche épitaxiale (20) est développée par épitaxie en phase vapeur au moyen d'un ou plusieurs gaz de source sélectionnés entre le triméthylegallium, le triméthylaluminium et l'ammoniac.

19. Procédé de fabrication selon l'une quelconque des revendications précédentes, comprenant les étapes de formation d'un masque (14) comprenant une pluralité desdites ouvertures (6) et la croissance des couches tampon et épitaxiale (12, 20) à partir de ladite pluralité des ouvertures.

20. Procédé de fabrication selon la revendication 2 ou la revendication 4, dans lequel, après la coalescence de la croissance latérale à partir des ouvertures, le taux de croissance verticale de la couche épitaxiale coalescée (20) est augmenté.

21. Procédé de fabrication selon l'une quelconque des revendications précédentes, dans lequel le substrat est masqué au moyen d'une technique sélectionnée entre le dépôt chimique en phase vapeur assisté par plasma, la pulvérisation, la pulvérisation réactive, le dépôt par faisceau électronique et l'oxydation thermique.

22. Procédé de fabrication selon l'une quelconque des revendications précédentes, dans lequel la couche tampon (12) est développée par épitaxie en phase vapeur utilisant le triméthylegallium, le triméthylaluminium et l'ammoniac comme gaz de source.

23. Procédé de fabrication selon la revendication 1, dans lequel le substrat (10) est un substrat de carbure de silicium, et dans lequel la couche tampon (12) est une couche de AlₓGa₁₋ₓN où 0 < X ≤ 1 et est développée à une épaisseur supérieure à l'épaisseur du masque.
